# EUROPEAN PATENT SPECIFICATION

(11) **EP 1 724 819 B1**
(45) Date of publication and mention of the grant of the patent: **07.07.2010**
(21) Application number: 05720184.0
(22) Date of filing: 07.03.2005
(51) Int. Cl.: H01L 21/304, C09K 3/14

(54) **POLISHING AGENT AND POLISHING METHOD**
POLIERMITTEL UND POLIERVERFAHREN
AGENT DE POLISSAGE ET PROCEDE DE POLISSAGE

(30) Priority: 08.03.2004 JP 2004063366; 20.10.2004 JP 2004305238
(43) Date of publication of application: 22.11.2006
(73) Proprietor: Asahi Glass Company, Limited, Chiyoda-ku, Tokyo 100-8405 (JP); SEIMI CHEMICAL CO., LTD., Chigasaki-city, Kanagawa, 253-8585 (JP)
(72) Inventor: TAKEMIYA, Satoshi c/o Asahi Glass Company, Limited, Kanagawa 2218755 (JP); SHINMARU, Sachie; c/o Seimi Chemical Co., Ltd.,, Kanagawa 2538585 (JP)
(74) Representative: Müller-Boré & Partner Patentanwälte
(86) International application number: PCT/JP2005/003912
(87) International publication number: WO 2005/086213

(56) References cited:
- WO-A1-01/17006
- JP-A- 2001 139 937
- JP-A- 2001 139 937
- JP-A- 2004 031 442
- JP-A- 2004 031 443
- JP-A- 2004 031 443
- US-A- 5 981 394
- US-A1- 2005 050 803

## Description

The present invention relates to a polishing composition to be used in a process for producing a semiconductor device. More particularly, it relates to a polishing composition which is suitable for forming an embedded metal wiring in which a Cu-based metal is used as a material for wirings and a tantalum-based metal is used as a material for barrier layers, and a method for polishing a surface to be polished of a semiconductor integrated circuit device using the polishing composition.

Recently, as the integration and functionality of semiconductor integrated circuits have been increasing, there has been a demand for development of microfabrication techniques for miniaturization and densification. Planarization techniques for interlayer insulating films and embedded wirings are important in semiconductor device production processes, in particular, in the process of forming multilayered wirings. That is, as the multilayered wirings are increasingly formed due to the miniaturization and densification in the semiconductor production processes, the degree of irregularities tends to increase in the surfaces of the individual layers, resulting in a situation where the step height exceeds the depth of focus in lithography. In order to prevent such a problem, high planarization techniques are important in the process of forming multilayered wirings.

As the material for such wirings, Cu has attracted attention because of its lower resistivity compared with conventionally used Al alloys and also because of its excellence in electromigration resistance. Since the vapor pressure of copper chloride gas is low, it is difficult to form Cu into the shape of wirings by Reactive Ion Etching (RIE) which has been conventionally used. Therefore, in order to form the wirings, a Damascene method is used. In this method, concave portions such as trench patterns and via holes for wirings, are formed in an insulating layer. A barrier layer is then formed thereon, and then Cu is deposited so as to be embedded in the trench portions to form a film by sputtering, plating or the like. Subsequently, the excess Cu and barrier layer are removed by Chemical Mechanical Polishing (hereinafter referred to as "CMP") until the surface of the insulating layer is exposed, other than the concave portions, whereby the surface is planarized to form an embedded metal wiring. Recently, a Dual Damascene method has been predominantly used, in which Cu wirings and via holes embedded with Cu are simultaneously formed.

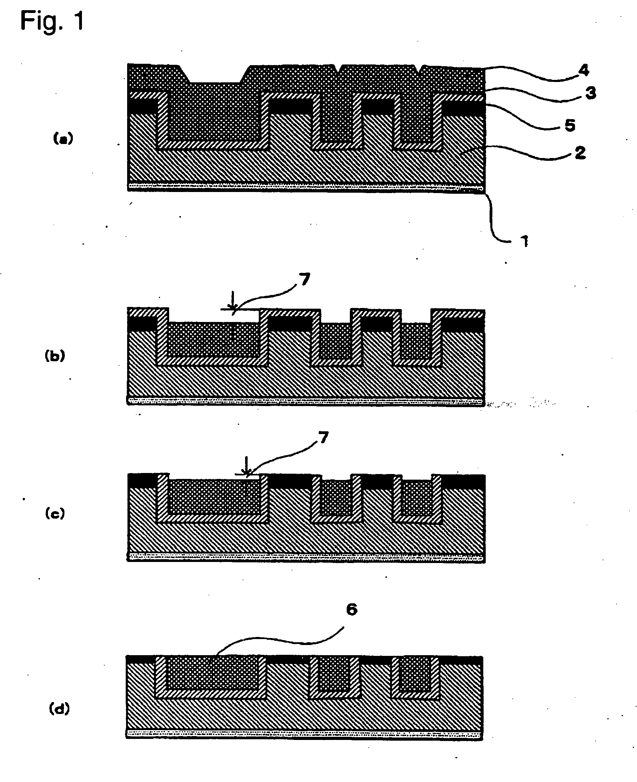

In the formation of Cu embedded wirings, in order to prevent Cu from diffusing into the insulating layer, a barrier layer composed of tantalum, a tantalum alloy or a tantalum compound such as tantalum nitride, is formed. Therefore, in the portions other than those corresponding to Cu-embedded wirings, the exposed barrier layer must be removed by CMP. However, since the barrier layer is significantly harder than Cu, it is often not possible to achieve a sufficient removal rate. Accordingly, a two-stage polishing method has been proposed, which includes a first polishing step of removing the excess metal wiring layer and a second polishing step of removing the excess barrier layer, as shown in Fig. 1.

Fig. 1 includes cross-sectional views which show a method for forming embedded wirings by CMP. Fig. 1(a) shows the state before polishing; Fig. 1(b) shows the state after the first polishing step in which an excess metal wiring layer 4 is removed; Fig. 1(c) shows the state in the course of the second polishing step in which the excess barrier layer 3 is removed; and Fig. 1(d) shows the state after the second polishing step. First, as shown in Fig. 1(a), trenches are formed on an insulating layer 2. They are trenches for forming embedded wirings 6 on an Si substrate 1. The barrier layer 3 is formed thereon, and the metal wiring layer 4 (Cu film) is formed further thereon. The excess metal wiring layer 4 is removed in the first polishing step, and the excess barrier layer 3 is removed in the second polishing step. Usually, after the first polishing step, loss of the metal wiring layer called dishing 7 occurs. Accordingly, the second polishing step is required to achieve excellent planarization by completely removing an excess barrier layer on the insulating layer, as shown in Fig. 1(c) and further by removing the insulating layer so that the still remaining dishing 7 will be flush with the metal wiring layer, as shown in Fig 1(d). Further, when a low-dielectric constant material is used for the insulating layer 2, there is also a case where a cap layer 5 is formed between the insulating layer 2 and the barrier layer. In such a case, there is a case where planarization is carried out while the cap layer is permitted to remain or a case where polishing is carried out until the low-dielectric constant material is exposed by completely removing the cap layer. Fig. 1(d) shows a case where planarization is carried out while the cap layer is permitted to remain.

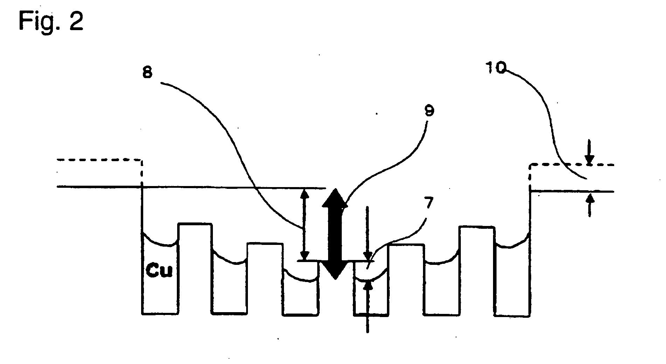

Thus, the planarization is carried out by polishing, but in CMP using the conventional polishing composition, an increase in dishing and erosion in the Cu-embedded wirings 6 will give rise to problems. Here, dishing signifies a state in which the metal wiring layer 4 is over-polished so that the central part thereof is concaved as shown in reference numeral 7 in Fig. 1(c) or Fig. 2, and is likely to occur in a wide wiring portion. Erosion is likely to occur in a narrow wiring portion or a dense wiring portion, and signifies such a phenomenon that the insulating layer 2 in the wiring portion is over-polished and the insulating layer 2 becomes thin as compared with an insulating layer portion (Global portion) having no wiring patterns as shown in Fig. 2. Namely, an erosion portion 8 results, which is more polished than a polished portion 10 of the Global portion. Further, in Fig. 2, the barrier layer 3 is omitted.

When the conventional polishing composition is used, the removal rate of the barrier layer 3 is smaller than the removal rate of the metal wiring layer 4, so that Cu in the wiring portions is over-polished while the barrier layer 3 is being removed, resulting in a large extent of dishing. Furthermore, the polishing pressure applied to the barrier layer 3 and the insulating layer 2 therebeneath in a highly dense wiring portion becomes relatively greater than that applied to a less dense wiring portion, so that the removal rate in the second polishing step largely differs depending on the wiring density, and as a result, the insulating layer 2 in the highly dense wiring portion is over-polished, resulting in a large extent of erosion. When such dishing or erosion occurs, the wiring resistance tends to increase and electromigration tends to readily occur, resulting in the reduction of the reliability of devices.

Tantalum and tantalum compounds to be used for the barrier layer are difficult to be etched chemically. Because of their higher hardness than Cu, tantalum and tantalum compounds are difficult to be removed mechanically by polishing. If abrasive particles with a higher hardness are used in order to increase the removal rate, scratches will occur in the soft Cu wirings, resulting in problems such as electrical defects. If the concentration of abrasive particles in the polishing composition is increased, it becomes difficult to maintain the dispersion of the abrasive particles in the polishing composition, and problems are likely to occur in the dispersion stability, such as sedimentation and gelation with time.

In CMP, it is necessary to prevent corrosion of Cu during polishing. Benzotriazole (hereinafter referred to as BTA) and its derivatives are known as most effective and widely used corrosion inhibitors for Cu and copper alloys (for example, "Mechanism of Corrosion Inhibition of Benzotriazole-based Inhibitor and Its Application (Takenori Notoya, Japan Association of Corrosion Control, 1986, p. 1). The BTA forms a dense film on the surface of Cu and copper alloys and inhibits oxidation-reduction reactions to thus prevent etching. Therefore, BTA is an effective additive to prevent dishing in Cu wiring portions. It is known to prevent dishing by incorporating BTA or its derivative to the polishing composition so as to form a protective film on the surface of Cu (e.g. USP 5,770,095). However, there has been a problem such that if it is attempted to cope with dishing only by increasing the amount of BTA, the removal rate of Cu lowers, and the removal time becomes long, whereby defects of dishing and erosion may sometimes increase.

Heretofore, a water-soluble polymer has been studied as one of Cu protective film forming reagents to suppress dishing. Each of them is a polishing composition having a large removal rate ratio of a metal to a barrier layer (metal/barrier layer), and also having a large removal rate ratio of a metal to an insulating layer (metal/insulating layer). Namely, it is designed to suppress polishing of the barrier layer and insulating layer while polishing and removing Cu at a high speed (e.g. JP-A-2001-144047, JP-A-2001-144048, JP-A-2001-144049, JP-A-2001-1440451 and JP-A-2003-188120).

Further, a water soluble polymer has been studied also for a polishing composition to be used in a process for producing a multilayer wiring comprising a copper layer and a low-dielectric insulating layer for the purpose of suppressing a delay of signals, which has been developed in recent years (e.g. JP-A-2003-68683).

However, these studies are all related to the first polishing step of polishing and removing Cu. Namely, with regard to a polishing composition in the second polishing step where the barrier layer is polished at a high speed, Cu is polished at an appropriate removal rate, and the insulating layer is removed to achieve an excellent planarization, no effective polishing composition has been found, heretofore.

This is because while the polishing composition in the first polishing step is required to mainly polish metal wiring at a high removal rate, the polishing composition in the second polishing step is required to polish a barrier layer at a high removal rate and further polish an insulating layer at a higher removal rate than that of metal wiring, and thus the properties required for the respective compounds are significantly different.

As stated above, the roles of the second polishing step in CMP are to completely remove unnecessary portions of the barrier layer and to reduce dishing formed in the first polishing step. In Fig. 1, if the degree of dishing formed in the first polishing step is thinner than the thickness of the barrier layer, in the second polishing step, it is possible to remove dishing simply by removing only the barrier layer, without being required to polish the metal wiring and the insulating layer. However, the thickness of the barrier layer is usually thin at a level of from 20 to 40 nm, and further, Cu is polished and removed at a high speed in the first polishing step, and therefore, it is extremely difficult to suppress dishing to be thinner than the thickness of the barrier layer. Further, in a case where there is a distribution in the Cu removal rate in the first polishing step, it is required to carry out over-polishing to completely remove unnecessary Cu residue in the wafer, whereby it tends to be more difficult to suppress dishing to a low level.

Accordingly, in the second polishing step, it is required to achieve excellent planarization by restoring dishing which is formed in the first polishing step and which is more than the thickness of the barrier layer. Further, usually, as shown in Fig. 2, with regard to an especially thin wiring or a high density wiring, the insulating layer 2 in the wiring portion tends to be excessively polished as compared with the insulating layer portion (Global portion) having no wiring patterns, whereby the insulating layer 2 is likely to be thin. In recent years, as the generation of semiconductor advances and the wiring portion becomes thinner, reduction of such erosion has been a serious problem to be solved.

US-patent 5,981,394 describes a chemical-mechanical polishing method having the step of subjecting a film to be polished, provided on a main surface of a substrate, and having a projection portion and a recess portion on a surface thereof, to polishing and etching, wherein the projection portion of the film to be polished is mechanically polished and chemically etched while covering the recess portion with a protective film to protect it from being chemically etched by supplying a protecting agent on the film to be polished.

US-A-2005/050803 describes a polishing slurry containing at least one of a surfactant and an organic solvent, and a metal oxide dissolving agent and water, or polishing slurry containing water and abrasive of which surface has been modified with an alkyl group, and preferably, it further contains a metal oxidizer, water-soluble polymer, and metal inhibitor.

Accordingly, it is an object of the present invention to provide a polishing composition for polishing a surface to be polished in the production of a semiconductor integrated circuit device, which makes it possible to form an embedded wiring portion with high reliability and electrical characteristics by preferentially polishing a convex portion while suppressing preferentially polishing of a concave portion, at a high removal rate. More particularly, it is an object of the present invention to provide a polishing composition for polishing a surface to be polished having a metal wiring layer and a barrier layer formed on an insulating layer, which makes it possible to form an embedded wiring portion with few scratches, high reliability and excellent electrical characteristics while suppressing dishing and erosion, and having a high removal rate of a barrier layer, and which is made of a slurry having abrasive particles dispersed, and is sufficiently stable i.e. not susceptible to e.g. sedimentation or gelation with time. Other objects and advantages of the present invention will be apparent from the following description.

Embodiment 1 of the present invention is to provide a chemical mechanical polishing composition for polishing a surface to be polished in the production of a semiconductor integrated circuit device, which comprises (A) fine oxide particles, (B) pullulan which has an average molecular weight of from 50,000 to 1,000,000, and (C) water.

Embodiment 2 is to provide the polishing composition according to Embodiment 1, which further contains (D) an oxidizing agent, and (E) a compound represented by the formula 1: 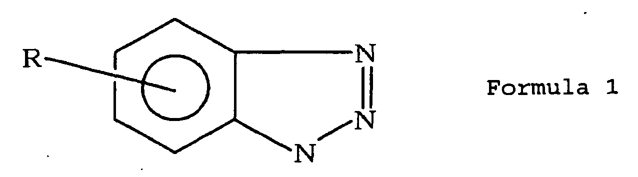 wherein R is a hydrogen atom, a C₁₋₄ alkyl group, a C₁₋₄ alkoxy group or a carboxylic acid group.

Embodiment 3 is to provide the polishing composition according to Embodiment 1 or 2, wherein the component (A) is made of at least one material selected from the group consisting of silica, alumina, cerium oxide, zirconium oxide, titanium oxide, tin oxide, zinc oxide and manganese oxide.

Embodiment 4 is to provide the polishing composition according to any one of Embodiments 1 to 3, wherein the component (A) is silica fine particles.

Embodiment 5 is to provide the polishing composition according to any one of Embodiments 1 to 4, wherein the component (A) is contained in an amount of from 0.1 to 20 mass%, the component (B) is contained in an amount of from 0.005 to 20 mass%, and the component (C) is contained in an amount of from 40 to 98 mass%, to the total mass of the polishing composition

Embodiment 6 is to provide the polishing composition according to any one of Embodiments 2 to 5, wherein the component (D) is contained in an amount of from 0.01 to 50 mass%, and the component (E) is contained in an amount of from 0.001 to 5 mass%, to the total mass of the polishing composition.

Embodiment 7 is to provide the polishing composition according to any one of embodiments 1 to 6, wherein the component (A) is present in an amount of from 1 to 15 mass%, to the total mass of the polishing composition.

Embodiment 8 is to provide the polishing composition according to any one of embodiments 1 to 7, wherein the component (C) is present in an amount of from 60 to 90 mass%, to the total mass of the polishing composition.

Embodiment 9 is to provide the polishing composition according to any one of embodiments 1 to 8, wherein the component (D) is present in an amount of from 0.5 to 5 mass%, to the total mass of the polishing composition.

Embodiment 10 is to provide the polishing composition according to any one of embodiments 1 to 9, wherein the component (E) is present in an amount of from 0.01 to 0.5 mass%, to the total mass of the polishing composition.

Embodiment 11 is to provide the polishing composition according to any one of embodiments 1 to 10, wherein the fine oxide particles have a mean particle diameter from 5 to 500 nm.

Embodiment 12 is to provide the polishing composition according to embodiments 11, wherein the fine oxide particles have a mean particle diameter from 10 to 300 nm.

Embodiment 13 is to provide the polishing composition according to any one of embodiments 1 to 12, wherein the component (B) has an average molecular weight of from 50,000 to 300,000.

Embodiment 14 is to provide the polishing composition according to any one of embodiments 1 to 13, which further comprises an acid selected from the group consisting of nitric acid, sulfuric acid and carboxylic acid.

Embodiment 15 is to provide the polishing composition according to embodiment 14, wherein the acid is present in an amount of from 0.01 to 20 mass%, to the total mass of the polishing composition.

Embodiment 16 is to provide the polishing composition according to embodiment 14 or 15, which further comprises a basic compound selected from the group consisting of ammonia, potassium hydroxide and a quaternary ammonium hydroxide.

Embodiment 17 is to provide a method for polishing a surface to be polished, which comprises supplying a polishing composition to a polishing pad, and bringing the surface to be polished into contact with the polishing pad, to carry out polishing by relative movement between them, wherein the polishing composition as defined in any one of Embodiments 1 to 16 is used at a polishing stage after a barrier layer is exposed by polishing a metal wiring layer.

According to the present invention, in polishing a surface to be polished in the production of a semiconductor integrated circuit device, it is possible to form an embedded wiring portion with few scratches, high reliability and excellent electrical characteristics while dishing or erosion is suppressed, by preferentially polishing a convex portion while suppressing preferential polishing of a concave portion, at a high removal rate.
Fig. 1 is schematic sectional views of a semiconductor integrated circuit device in process steps which illustrate a method for forming embedded wirings by CMP.
Fig. 2 is a schematic sectional view of a semiconductor integrated circuit device to illustrate the definitions of dishing and erosion.

### MEANINGS OF REFERENCE SYMBOLS

- 1: Si substrate
- 2: Insulating layer
- 3: Barrier layer
- 4: Metal wiring layer
- 5: Cap layer
- 6: Embedded wiring
- 7: Dishing portion
- 8: Erosion portion
- 9: Maximum step height
- 10: Polished portion of Global portion

Now, practical embodiments of the present invention will be described with reference to drawings, tables, formulas, Examples and so on. However, these drawings, tables, formulas, Examples and descriptions are to exemplify the present invention, and they do not limit the scope of the present invention. Other practical embodiments would belong to the present invention as long as they meet the concept of the present invention.

The polishing composition according to the present invention is a chemical mechanical polishing composition for polishing a surface to be polished in the production of a semiconductor integrated circuit device, which comprises (A) fine oxide particles, (B) pullulan which has an average molecular weight of from 50,000 to 1,000,000, and (C) water. It is preferred that the polishing composition further contains (D) an oxidizing agent, and (E) a compound represented by the formula 1: 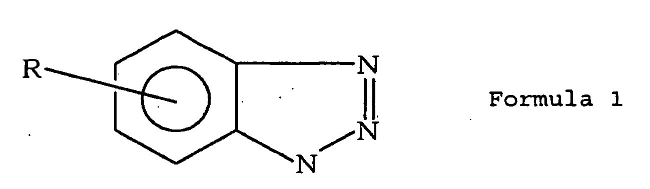 wherein R is a hydrogen atom, a C₁₋₄ alkyl group, a C₁₋₄ alkoxy group or a carboxylic acid group.

If such a polishing composition is used in the process for production of a semiconductor integrated circuit device, it is possible to polish its surface and readily form a layer having a flat surface made of e.g. an insulating layer. More particularly, it is possible to realize a high removal rate and suppress dishing and erosion by preferential polishing of a convex portion while suppressing preferential polishing of a concave portion. Further, it is possible to form an embedded wiring portion with little scratches, high reliability and excellent electrical characteristics. The polishing composition of the present invention is also excellent in the dispersion stability of abrasive particles.

The present invention is particularly useful in a case where the surface to be polished is a surface to be polished of a semiconductor integrated circuit device having a metal wiring layer, a barrier layer and an insulating layer formed. Here, in the present invention, "surface to be polished" is meant for a surface at a middle stage, which is exposed in a process for producing a semiconductor integrated circuit device. Accordingly, it may be a surface where the metal wiring layer, the barrier layer and the insulating layer do not coexist.

Fine oxide particles of the component (A) in the polishing composition are abrasive particles. Specifically, they are preferably at least one member selected from the group consisting of silica, alumina, cerium oxide (ceria), zirconium oxide (zirconia), titanium oxide (titania), tin oxide, zinc oxide, germanium oxide and manganese oxide. Various types of silica produced by known methods may be used. Examples thereof include fumed silica prepared by subjecting silicon tetrachloride to vapor phase synthesis in a hydrogen oxygen flame, colloidal silica prepared from sodium silicate using an ion exchange process and colloidal silica prepared by liquid phase hydrolysis of a silicon alkoxide.

Similarly, colloidal alumina is also preferably used. Cerium oxide, zirconium oxide, titanium oxide, tin oxide and zinc oxide prepared by a liquid phase process or vapor phase process are also preferably used. Among them, colloidal silica is more preferred since it can be obtained with high purity and with a uniform particle size.

The mean particle diameter of the compound (A) is preferably from 5 to 500 nm, more preferably from 10 to 300 nm in view of the polishing characteristics and the dispersion stability. Further, it is preferred that the concentration of the component (A) in the polishing composition of the present invention is appropriately set within a range of from 0.1 to 20 mass%, based on the total mass of the polishing composition in consideration of the removal rate, uniformity, material selectivity, dispersion stability and others. It is more preferred that the above concentration is within a range of from 1 to 15 mass%, based on the total mass of the polishing composition.

The compound (B) is used for accelerating the removal rate of an insulating layer. In a case of using silicon dioxide for an insulating layer, the removal rate at a portion where no pattern is formed (Global portion) in a patterned wafer usually tends to be slow as compared with the removal rate of a blanket wafer where no pattern is formed. On the other hand, the insulating layer at a portion where a pattern is formed, has a large area in contact with the polishing composition, whereby the removal rate tends to be high. Accordingly, even within one wafer, the removal rates of the insulating layer are substantially different between a Global portion and a wiring portion, and therefore erosion expands in the second polishing step. As the generation advances and the line width becomes narrow, this tendency will be remarkable, whereby it tends to be difficult to suppress erosion at a thin wire portion.

In such a case, if the compound (B) is added to the polishing composition, polishing at the Global portion is accelerated by preferential polishing of a convex portion while suppressing preferential polishing of a concave portion, whereby it is possible to realize planarization and reduce erosion. The reason is not clearly understood, but is considered to be such that the removal rate is increased in a wide range by interaction between hydroxyl groups on the surface of the abrasive particles, hydroxyl groups of the component (B) and hydroxyl groups on the surface of the insulating layer. Accordingly, such interaction is considered to take place, if the abrasive particles are an oxide and the surface portion to be polished is an oxide film. In a case where the abrasive particles are silica and the surface portion to be polished is composed mainly of silicon dioxide, the interaction employing the component (B) as a medium is more effective for the planarization characteristics.

Pullulan is a polysaccharide which is formed in such a manner that maltotriose having termolecular glucose α-1,4 bonded is further α-1,6 bonded. When the component (B) has a weight average molecular weight of from 10,000 to 1,000,000, its effect becomes high. The presence of hydroxyl groups is considered to be an important factor. If the weight average molecular weight is less than 10,000, the effect for improving the removal rate will be small, and if it exceeds 1,000,000, no further remarkable increase in the effect can be expected. It is particularly preferably from 50,000 to 300,000. Here, the weight average molecular weight can be measured by gel permeation chromatography (GPC).

From the viewpoint of obtaining a sufficient effect for accelerating the polishing, it is preferred that the concentration of the component (B) in the polishing composition is appropriately set within a range of from 0.005 to 20 mass% in consideration of the removal rate, the homogeneity of the polishing slurry, etc.

The component (C) is a solvent for dispersing fine oxide particles and dissolving reagents. It is preferably pure water or deionized water. Water has a function of controlling the fluidity of the polishing composition, and its content may be set appropriately in accordance with the desired polishing characteristics such as the removal rate and planarization characteristics. It is contained preferably within a range of from 40 to 98 mass%, particularly preferably within a range of from 60 to 90 mass%, in the polishing composition.

The component (D) is used to form an oxide film on the surface of the barrier layer and to accelerate the polishing of the barrier layer by mechanically removing the oxide film from the surface to be polished.

The component (D) is preferably at least one member selected from the group consisting of hydrogen peroxide, iodates, periodates, hypochlorites, perchlorates, persulfates, percarbonates, perborates and perphosphates. As the iodates, periodates, hypochlorites, perchlorates, persulfates, percarbonates, perborates and perphosphates, ammonium salts and alkali metal salts such as potassium salts, may be used. Among them, hydrogen peroxide is more preferred since it contains no alkali metal components and produces no hazardous by-products.

From the viewpoint of obtaining a sufficient effect for accelerating the polishing, it is preferred that the concentration of the component (D) in the polishing composition is appropriately set within a range of from 0.01 to 50 mass% in the polishing composition in consideration of the removal rate, the homogeneity of the polishing slurry, etc. It is more preferably from 0.5 to 5 mass%.

The component (E) has a function of forming a protective film on the surface of metal wiring in order to prevent dishing of the metal wiring portion. When the metal wiring is composed of Cu, it may be any compound so long as it physically or chemically adsorbs on the surface of Cu to form a film to prevent elution of Cu. In the formula (1), R is a hydrogen atom, a C₁₋₄ alkyl group, a C₁₋₄ alkoxy group or a carboxyl group.

Specific examples of the compound include BTA, tolyltriazole (TTA) which is obtained by substituting a methyl group for a hydrogen atom at the 4- or 5-position of the benzene ring of BTA, and benzotriazole-4-carboxylic acid which is obtained by substituting a carboxyl group for the hydrogen atom. They may be used alone or in combination as a mixture of two or more of them. In view of the polishing characteristics, the component (E) is contained preferably from 0.001 to 5 mass%, more preferably from 0.01 to 0.5 mass%, in the polishing composition.

In addition to the components (A) to (C) or the components (A) to (E), the polishing composition preferably contains an acid. Such an acid is preferably at least one member selected from the group consisting of nitric acid, sulfuric acid and carboxylic acid. Among them, preferred is an oxidative oxo acid or nitric acid free of a halogen. Further, the concentration of the acid in the present polishing composition is preferably from 0.01 to 20 mass%. By the addition of the acid, it is possible to increase the removal rate of the barrier layer or the insulating film. Further, it is possible to improve the dispersion stability of the present polishing composition.

Further, in order to adjust the pH of the polishing composition to a predetermined value, a basic compound may be added to the polishing composition together with the acid. As the basic compound, ammonia, potassium hydroxide, or a quaternary ammonium hydroxide such as tetramethylammonium hydroxide or tetraethylammonium hydroxide (hereinafter referred to as "TEAH") may, for example, be used. When it is desired that no alkali metals be contained, ammonia is suitable. Further, also a case where the components corresponding to the components (A) to (C) or the components (A) to (E) treated with the acid or the basic compound are used as components for the polishing composition, corresponds to the addition of the acid or the basic compound as described above.

The present polishing composition may be used in a wide pH range of from 2 to 10. In view of the polishing characteristics and the dispersion stability of the polishing composition, when silica is used as fine oxide particles, the pH is preferably at most 5 or at least 7, and the acidic range (pH 2 to 5) or the neutral range-basic range (pH 7 to 10) is selected for use depending on the desired removal rate of the metal wiring (for example Cu).

In a case where the fine oxide particles are alumina or ceria, the pH is adjusted to an optimum value in consideration of the isoelectric point or the gelation range thereof. Accordingly, a pH buffering agent may be used. Such a pH buffering agent may be any substance as long as it has a usual pH buffering ability, but is preferably at least one substance selected from the group consisting of succinic acid, citric acid, oxalic acid, phthalic acid, tartaric acid and adipic acid which are polycarboxylic acids. Glycyl glycine or alkali metal carbonate may also be used. Here, the concentration of the pH buffering agent in the polishing composition is preferably from 0.01 to 10 mass%, based on the total mass of the polishing composition.

The polishing composition of the present invention is not necessarily required to be supplied to the polishing site in the form of a mixture having all the polishing materials preliminarily mixed. At the time of supplying it to the polishing site, the polishing materials may be mixed to constitute the composition of the polishing composition.

The present polishing composition is suitable for planarization by polishing a surface to be polished of a semiconductor integrated circuit device having an insulating layer formed. Since the polishing composition can control the removal rate of a metal wiring (for example Cu), it is more suitable for use in polishing a surface to be polished having a metal wiring layer, a barrier layer and an insulating layer formed. In such a case, the polishing composition is highly effective when the barrier layer is a layer composed of at least one member selected from the group consisting of tantalum, a tantalum alloy and a tantalum compound. However, the polishing composition can also be used for films composed of other metals, etc., and the sufficient effect can be obtained also when the barrier layer is a film composed of a metal or a metal compound other than tantalum, for example, Ti, TiN, TiSiN or WN.

Namely, the polishing composition has both functions of high speed polishing of the barrier layer and planarization of the insulating layer. In a case where only the latter function is used, it is also effective for a planarization process of so-called interlayer insulating layers, a forming process for shallow trench isolation (STI) or the like.

The present polishing composition is highly effective when the metal wiring layer is composed of at least one member selected from the group consisting of Cu, copper alloys and copper compounds, but it is also possible to apply it when the metal wiring layer is a metal film composed of a metal other than Cu, for example, Al, W, Ag, Pt, or Au.

Further, as the above insulating layer, a silicon oxide film is known. Such a silicon oxide film is usually one deposited by a CVD method using tetraethoxysilane (TEOS).

Further, in recent years, for the purpose of suppressing a delay of signals, a case of using a low-dielectric insulating layer instead of such an SiO₂ film is increased. As such a material, an SiOC film obtained by a CVD method (chemical vapor deposition method) is known in addition to low-dielectric constant materials such as a film composed of fluorine-added silicon oxide (SiOF), an organic SOG (a film containing an organic component formed by "Spin on glass"), and a porous silica film.

The SiOC film by the CVD method is an extension of the prior art from the viewpoint of the process technique, and a mass production technique in a wide application range is already available by carrying out an appropriate process tuning. Accordingly, a technique for planarization of a film using such an insulating layer is desired.

An organic silicon material as a low-dielectric constant material may, for example, be one known by tradename: Black Diamond (relative dielectric constant: 2.7, Applied Materials Inc.), tradename: Coral (relative dielectric constant: 2.7, Novellus Systems Inc.) or Aurora 2.7 (relative dielectric constant: 2.7, ASM Japan K.K.). Especially, a compound having an Si-CH₃ bond is preferably used.

The polishing composition of the present invention may suitably be used in a case where such various insulating layers are employed.

Further, in recent years, when a low-dielectric constant film of an organic silicon material is used, one having a cap layer formed thereon has been predominantly used. It is an object of the cap layer to improve the adhesion between the barrier layer and the organic silicon material and to improve the etching properties of the organic silicon material. The silicon oxide film to be used for a cap layer is usually made of a crosslinked structure of Si and O, and the ratio of atomicity of Si to O is 1:2. However, there is a case where atoms such as N or C are incorporated, and there is also a case where e.g. Si₃N₄ and SiC are incorporated as accessory components. The polishing composition of the present invention may suitably be used also in a case where such a cap layer is employed.

The polishing composition of the present invention is applicable to a polishing method which comprises supplying a polishing composition to a polishing pad, and bringing the surface to be polished into contact with the polishing pad, to carry out polishing by relatively moving the surface to be polished and the polishing pad. If necessary, polishing may be performed while the surface of the polishing pad is subjected to conditioning by bringing a pad conditioner into contact with the surface of the polishing pad.

The present polishing composition is suitably used for a method for forming an embedded metal wiring, in which concave portions such as trench patterns or via holes for wirings are formed in an insulating layer on a substrate, then, a barrier layer is formed thereon, and then e.g. Cu is deposited to fill the concave portions by sputtering, plating or the like, to have a surface to be polished and in which method, the Cu and the barrier layer are removed by CMP until the surface of the insulating layer other than at the concave portions are exposed.

In a two-stage polishing process as shown in Fig. 1, the polishing composition of the present invention may be used in any step of the polishing. Especially when the polishing composition is used in a second polishing step in which the surface is polished from the state shown in Fig. 1(b) as a polishing stage after appearance of the barrier layer, to the state shown in Fig. 1(d), dishing or erosion scarcely results, such being desirable.

Now, the present invention will be described in further detail with reference to Examples of the present invention (Examples 1 to 3, and Examples 8 to 12) and Comparative Examples (Examples 4 to 7).

### (1) Preparation of polishing composition

Each polishing composition in Examples 1 to 7 was prepared as follows. An acid, a basic compound and a pH buffering agent were added to water, followed by stirring for 10 minutes to obtain liquid a. Then, the component (E) was dissolved in ethylene glycol so that the solid content concentration would be 40 mass%, and the resultant was added to liquid a. Then, the component (B) was further added thereto, followed by stirring for 10 minutes to obtain liquid b.

Then, an aqueous dispersion of the component (A) was slowly added to the liquid b, and then a basic compound was slowly added thereto to adjust the pH to 3. An aqueous solution of the component (D) was further added thereto, followed by stirring for 30 minutes, to obtain a polishing composition. Table 1 shows the types of the component (B), the component (E) and the compound (A) used in each Example and the concentrations (mass%) thereof, based on the total mass of the polishing composition. Table 2 shows the types of the component (D), the acid, the basic compound and the pH buffering agent used and the concentrations thereof, based on the total mass of the polishing composition. Pure water was used as water. Further, in Comparative Examples, materials shown in Table 1 were used instead of the compound (B).

### (2) Polishing conditions

Polishing was performed using the following apparatus under the following conditions.
Polishing apparatus: Fully automatic CMP apparatus MIRRA (made by APPLIED MATERIALS INC.)
Polishing pressure: 14 kPa
Rotational speed: Platen (machine platen) 123 rpm, head (substrate holding portion) 117 rpm
Polishing composition supply rate: 200 ml/min
Polishing pad: IC1000 (made by Rhodel, Inc.)

### (3) Objects to be polished

The following wafers were used.

### (3-1) Blanket wafers

### (a) Wafer for evaluating removal rate of Cu (metal wiring layer)

An 8-inch wafer comprising a substrate and a 1,500 nm-thick Cu layer deposited thereon by plating, was used.

### (b) Wafer for evaluating removal rate of tantalum (barrier layer)

An 8-inch wafer comprising a substrate and a 200 nm-thick tantalum layer deposited thereon by sputtering, was used.

### (c) Wafer for evaluating removal rate of SiO₂ (insulating layer)

An 8-inch wafer comprising a substrate and a 800 nm-thick SiO₂ layer deposited thereon by plasma CVD, was used.

### (d) Wafer for evaluating removal rate of SiOC (low-dielectric constant insulating layer)

An 8-inch wafer comprising a substrate and a 800 nm-thick SiOC layer deposited thereon by plasma CVD, was used.

### (3-2) Patterned wafer

An 8-inch wafer (tradename: 831 BDM000, made by International SEMAETECH) was used, which was fabricated by forming a line pattern with a line density of 50% and a line width of from 5 µm to 100 µm on an insulating layer formed on a substrate, forming a 25 nm-thick tantalum layer by sputtering on the line-pattern-formed insulating layer, and further forming thereon a 1,500 nm-thick Cu layer by plating.

### (4) Method for evaluating characteristics of polishing composition

The removal rate was calculated from the film thicknesses before and after polishing. For the measurement of the film thickness, with respect to Cu and tantalum, a sheet resistance measuring apparatus RS75 (made by KLA-TENCOR Corporation) was used, in which the thickness was calculated from the surface resistance by a four prove method, and with respect to the insulating layer, an optical interference-type, fully automatic film-thickness measuring apparatus UV1280SE (made by KLA-TENCOR Corporation) was used. For the evaluation of the planarization characteristics with respect to the dishing and erosion, a high resolution profiler HRP100 (made by KLA-TENCOR Corporation) was used, which measured the step height by using a stylus.

### (5) Evaluation of polishing characteristics of blanket wafers

The above respective blanket wafers were used to evaluate the removal rates of the metal wiring layer, the barrier layer and the insulating layer, respectively. The polishing composition having a composition in each of the above Examples was used in the evaluation.

Table 3 shows the removal rate (nm/min) of each of the Cu, tantalum, SiO₂ and SiOC films, obtained by using the blanket wafer. From the results, it is evident that the polishing composition of the present invention has a high removal rate of tantalum, and a relatively small removal rate of Cu. It is understood that if such characteristics are applied, a polishing composition can be obtained, which is suitable for polishing in the second polishing step where the barrier layer is required to be polished at a high removal rate and the insulating layer is required to be polished at a removal rate higher than that of the metal wiring.

### (6) Evaluation of polishing characteristics of pattern

The patterned wafers were used to evaluate dishing and erosion. When the patterned wafers were polished, a two-step polishing method including a first polishing step of removing the metal wiring layer and a second polishing step of removing the barrier layer was carried out. As the polishing composition for the first polishing step, a polishing composition was used, which contains alumina, hydrogen peroxide, citric acid, ammonium polyacrylate and water in the concentrations of 3 mass%, 4 mass%, 0.1 mass%, 0.05 mass% and 92.85 mass%, respectively, based on the total mass of the polishing composition. In the second polishing step, a polishing composition having a composition in the above each Example was used.

In each Example, a patterned wafer having tantalum at an excess portion completely removed by the first polishing step was prepared to evaluate the performance to eliminate a step height of the insulating layer by the polishing composition. At such a stage, the dishing was 10 nm and the erosion was 50 nm, at a position with the line width of 5 µm, and therefore the maximum step height (corresponding to the portion identified by symbol 9 in Fig. 2) was 60 nm.

By carrying out the second polishing step, the insulating layer of the wafer was removed for 60 seconds to measure how much the maximum step height in the wiring can be reduced. The value of the initial maximum step height-the maximum step height after polishing was taken as the reduction of step height (nm). From the results shown in Table 4, it can be understood that the polishing compositions in Examples are effective to reduce the step height.

The dispersion stability of the polishing composition was evaluated by assessing the change in the mean particle diameter by measuring the mean particle diameter immediately after the preparation thereof and that in one week after the preparation thereof. The mean particle diameter was measured using a Microtrac UPA particle analyzer (made by Nikkiso Co., Ltd.). O (good) showed an increase in the mean particle diameter within 50%, and X (bad) showed an increase in the mean particle diameter greater than 50% or one which caused gelation.

Further, based on the polishing composition in Example 1, also with respect to one in which the type of abrasive particles as the component (A) was changed (Examples 8 and 9), one in which the molecular weight of pullulan as the component (B) was changed (Example 10) and one in which BTA was changed to TTA and its amount was kept low (Examples 11 and 12), the polishing compositions may be prepared with the compositions shown in Tables 1 and 2, in the same manner as in Examples 1 to 7. When the polishing compositions (Examples 8 to 12) obtained are evaluated in the same manner as in Examples 1 to 7, it is possible to obtain the results shown in Tables 3 and 4.

In Examples 11 and 12, as shown in Table 3, the removal rates of tantalum, SiO₂ and SiOC were high. On the other hand, the removal rate of Cu was low, and as shown in Table 4, the reduction of step height increased.

Further, as a result of the observation by means of a microscope, no scratches were observed in the Cu wiring in Examples of the present invention.

**TABLE 1: Mw: Weight average molecular weight**

| Examples | Component (A) | | Component (B) or alternate | | Component (E) | |
|---|---|---|---|---|---|---|
| | Substance | Concentration (mass%) | Substance | Concentration (mass%) | Substance | Concentration (mass%) |
| 1 | Silica | 6 | Pullulan (Mw: 200,000) | 0.05 | BTA | 1 |
| 2 | Silica | 6 | Pullulan (Mw: 200,000) | 0.1 | BTA | 1 |
| 3 | Silica | 6 | Pullulan (Mw: 200,000) | 1 | BTA | 1 |
| 4 | Silica | 6 | Polyvinyl alcohol (Mw: 24,000) | 0.1 | BTA | 1 |
| 5 | Silica | 6 | Trehalose | 0.1 | BTA | 1 |
| 6 | Silica | 6 | Polyvinyl pyrrolidone (Mw: 9,000) | 0.1 | BTA | 1 |
| 7 | Silica | 6 | None | Nil | BTA | 1 |
| 8 | Alumina | 1 | Pullulan (Mw: 200,000) | 0.05 | TTA | 1 |
| 9 | Ceria | 1 | Pullulan (Mw: 200,000) | 0.05 | TTA | 1 |
| 10 | Silica | 6 | Pullulan (Mw: 100,000) | 0.1 | BTA | 1 |
| 11 | Silica | 6 | Pullulan (Mw: 200,000) | 0.05 | TTA | 0.5 |
| 12 | Silica | 6 | Pullulan (Mw: 200,000) | 0.05 | TTA | 0.2 |

**TABLE 2**

| Ex. | Component (D) | | Acid | | Basic compound | | pH buffering agent | |
|---|---|---|---|---|---|---|---|---|
| | Substance | Concentration (mass%) | Substance | Concentration (mass%) | Substance | Concentration (mass%) | Substance | Concentration v(mass%) |
| 1 | Hydrogen peroxide | 1 | Nitric acid | 0.6 | KOH | 0.6 | Citric acid | 0.2 |
| 2 | Hydrogen peroxide | 1 | Nitric acid | 0.6 | KOH | 0.6 | Citric acid | 0.2 |
| 3 | Hydrogen peroxide | 1 | Nitric acid | 0.6 | KOH | 0.6 | Citric acid | 0.2 |
| 4 | Hydrogen peroxide | 1 | Nitric acid | 0.6 | KOH | 0.6 | Citric acid | 0.2 |
| 5 | Hydrogen peroxide | 1 | Nitric acid | 0.6 | KOH | 0.6 | Citric vacid | 0.2 |
| 6 | Hydrogen peroxide | 1 | Nitric acid | 0.6 | KOH | 0.6 | Citric acid | 0.2 |
| 7 | Hydrogen peroxide | 1 | Nitric acid | 0.6 | KOH | 0.6 | Citric acid | 0.2 |
| 8 | Hydrogen peroxide | 3 | Nitric acid | 0.1 | Ammonia | 0.1 | Tartaric acid | 0.1 |
| 9 | Hydrogen vperoxide | 0 | Nitric acid | 0.1 | Ammonia | 0.1 | Succinic acid | 0.1 |
| 10 | Hydrogen peroxide | 1 | Nitric acid | 0.6 | KOH | 0.6 | Citric acid | 0.2 |
| 11 | Hydrogen peroxide | 0.5 | Nitric acid | 0.6 | KOH | 0.6 | Citric acid | 0.2 |
| 12 | Hydrogen peroxide | 0.2 | Nitric acid | 0.6 | KOH | 0.6 | Citric acid | 0.2 |

**TABLE 3**

| Ex. | Cu removal rate (nm/min) | Ta removal rate (nm/min) | SiO₂ removal rate (nm/min) | SiOC removal rate (nm/min) |
|---|---|---|---|---|
| 1 | 50 | 90 | 120 | 60 |
| 2 | 50 | 90 | 120 | 60 |
| 3 | 50 | 90 | 120 | 60 |
| 4 | 70 | 70 | 80 | 40 |
| 5 | 60 | 80 | 50 | 20 |
| 6 | - | - | - | - |
| 7 | 40 | 100 | 100 | 60 |
| 8 | 40 | 100 | 100 | 60 |
| 9 | 40 | 100 | 100 | 60 |
| 10 | 50 | 90 | 120 | 60 |
| 11 | 40 | 120 | 80 | 80 |
| 12 | 40 | 100 | 80 | 80 |

**TABLE 4**

| Ex. | Reduction of step height (nm) | Dispersion stability |
|---|---|---|
| 1 | 40 | ○ |
| 2 | 40 | ○ |
| 3 | 40 | ○ |
| 4 | 10 | ○ |
| 5 | 10 | ○ |
| 6 | - | × |
| 7 | 5 | ○ |
| 8 | 35 | ○ |
| 9 | 35 | ○ |
| 10 | 35 | ○ |
| 11 | 40 | ○ |
| 12 | 40 | ○ |

## Claims

1. A chemical mechanical polishing composition for polishing a surface to be polished in the production of a semiconductor integrated circuit device, which comprises:
(A) fine oxide particles,
(B) pullulan which has an average molecular weight of from 50,000 to 1,000,000, and
(C) water.

2. The polishing composition according to Claim 1, which further contains:
(D) an oxidizing agent, and
(E) a compound represented by the formula 1: 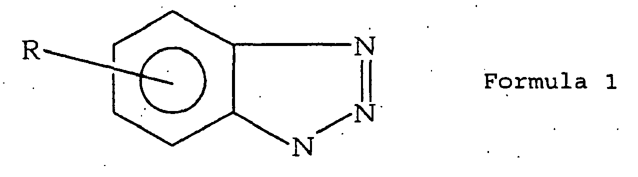 wherein R is a hydrogen atom, a C₁₋₄ alkyl group, a C₁₋₄ alkoxy group or a carboxylic acid group.

3. The polishing composition according to Claim 1 or 2, wherein the component (A) is made of at least one material selected from the group consisting of silica, alumina, cerium oxide, zirconium oxide, titanium oxide, tin oxide, zinc oxide and manganese oxide.

4. The polishing composition according to any one of Claims 1 to 3, wherein the component (A) is silica fine particles.

5. The polishing composition according to any one of Claims 1 to 4, wherein the component (A) is contained in an amount of from 0.1 to 20 mass%, the component (B) is contained in an amount of from 0.005 to 20 mass%, and the component (C) is contained in an amount of from 40 to 98 mass%, to the total mass of the polishing composition.

6. The polishing composition according to any one of Claims 2 to 5, wherein the component (D) is contained in an amount of from 0.01 to 50 mass%, and the component (E) is contained in an amount of from 0.001 to 5 mass%, to the total mass of the polishing composition.

7. The polishing composition according to any one of Claims 1 to 6, wherein the component (A) is present in an amount of from 1 to 15 mass%, to the total mass of the polishing composition.

8. The polishing composition according to any one of Claims 1 to 7, wherein the component (C) is present in an amount of from 60 to 90 mass%, to the total mass of the polishing composition.

9. The polishing composition according to any one of Claims 1 to 8, wherein the component (D) is present in an amount of from 0.5 to 5 mass%, to the total mass of the polishing composition.

10. The polishing composition according to any one of Claims 1 to 9, wherein the component (E) is present in an amount of from 0.01 to 0.5 mass%, to the total mass of the polishing composition.

11. The polishing composition according to any one of Claims 1 to 10, wherein the fine oxide particles have a mean particle diameter from 5 to 500 nm.

12. The polishing composition according to Claim 11, wherein the fine oxide particles have a mean particle diameter from 10 to 300 nm.

13. The polishing composition according to any one of Claims 1 to 12, wherein the component (B) has an average molecular weight of from 50,000 to 300,000.

14. The polishing composition according to any one of Claims 1 to 13, which further comprises an acid selected from the group consisting of nitric acid, sulfuric acid and carboxylic acid.

15. The polishing composition according to Claim 14, wherein the acid is present in an amount of from 0.01 to 20 mass%, to the total mass of the polishing composition.

16. The polishing composition according to Claim 14 or 15, which further comprises a basic compound selected from the group consisting of ammonia, potassium hydroxide and a quaternary ammonium hydroxide.

17. A method for polishing a surface to be polished, which comprises supplying a polishing composition to a polishing pad, and bringing the surface to be polished into contact with the polishing pad, to carry out polishing by relative movement between them, wherein the polishing composition as defined in any one of Claims 1 to 16 is used at a polishing step after a barrier layer is exposed by polishing a metal wiring layer.

## Patentansprüche

1. Chemisch-mechanische Polierzusammensetzung zum Polieren einer zu polierenden Oberfläche in der Herstellung einer integrierten Halbleiterschaltungsvorrichtung, welche
(A) feine Oxidteilchen,
(B) Pullulan, welches ein mittleres Molekulargewicht von 50000 bis 1000000 aufweist, und
(C) Wasser umfasst.

2. Polierzusammensetzung nach Anspruch 1, welche weiter
(D) ein Oxidationsmittel, und
(E) eine Verbindung, dargestellt durch die Formel 1: 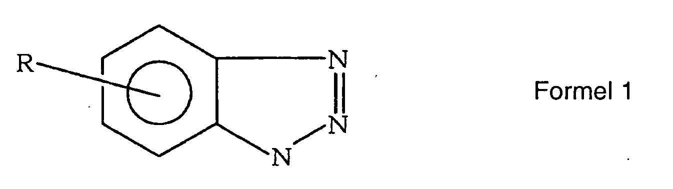 enthält, wobei R ein Wasserstoffatom, eine C₁₋₄ Alkylgruppe, eine C₁₋₄ Alkoxygruppe oder eine Carbonsäuregruppe ist.

3. Polierzusammensetzung nach Anspruch 1 oder 2, wobei die Komponente (A) aus mindestens einem Material, ausgewählt aus der Gruppe, bestehend aus Siliciumdioxid, Aluminiumoxid, Ceroxid, Zirconiumoxid, Titanoxid, Zinnoxid, Zinkoxid und Manganoxid hergestellt ist.

4. Polierzusammensetzung nach einem der Ansprüche 1 bis 3, wobei die Komponente (A) feine Siliciumdioxidteilchen ist.

5. Polierzusammensetzung nach einem der Ansprüche 1 bis 4, wobei die Komponente (A) in einer Menge von 0,1 bis 20 Massenprozent enthalten ist, die Komponente (B) in einer Menge von 0,005 bis 20 Massenprozent enthalten ist und die Komponente (C) in einer Menge von 40 bis 98 Massenprozent enthalten ist, bezogen auf die Gesamtmasse der Polierzusammensetzung.

6. Polierzusammensetzung nach einem der Ansprüche 2 bis 5, wobei die Komponente (D) in einer Menge von 0,01 bis 50 Massenprozent enthalten ist, und die Komponente (E) in einer Menge von 0,001 bis 5 Massenprozent enthalten ist, bezogen auf die Gesamtmasse der Polierzusammensetzung.

7. Polierzusammensetzung nach einem der Ansprüche 1 bis 6, wobei die Komponente (A) in einer Menge von 1 bis 15 Massenprozent vorliegt, bezogen auf die Gesamtmasse der Polierzusammensetzung.

8. Polierzusammensetzung nach einem der Ansprüche 1 bis 7, wobei die Komponente (C) in einer Menge von 60 bis 90 Massenprozent vorliegt, bezogen auf die Gesamtmasse der Polierzusammensetzung.

9. Polierzusammensetzung nach einem der Ansprüche 1 bis 8, wobei die Komponente (D) in einer Menge von 0,5 bis 5 Massenprozent vorliegt, bezogen auf die Gesamtmasse der Polierzusammensetzung.

10. Polierzusammensetzung nach einem der Ansprüche 1 bis 9, wobei die Komponente (E) in einer Menge von 0,01 bis 0,5 Massenprozent vorliegt, bezogen auf die Gesamtmasse der Polierzusammensetzung.

11. Polierzusammensetzung nach einem der Ansprüche 1 bis 10, wobei die feinen Oxidteilchen einen mittleren Teilchendurchmesser von 5 bis 500 nm aufweisen.

12. Polierzusammensetzung nach Anspruch 11, wobei die feinen Oxidteilchen einen mittleren Teilchendurchmesser von 10 bis 300 nm aufweisen.

13. Polierzusammensetzung nach einem der Ansprüche 1 bis 12, wobei die Komponente (B) ein mittleres Molekulargewicht von 50000 bis 300000 aufweist.

14. Polierzusammensetzung nach einem der Ansprüche 1 bis 13, welche weiter eine Säure umfaßt, ausgewählt aus der Gruppe, bestehend aus Salpetersäure, Schwefelsäure und Carbonsäure.

15. Polierzusammensetzung nach Anspruch 14, wobei die Säure in einer Menge von 0,01 bis 20 Massenprozent vorliegt, bezogen auf die Gesamtmasse der Polierzusammensetzung.

16. Polierzusammensetzung nach Anspruch 14 oder 15, welche weiter eine basische Verbindung umfaßt, ausgewählt aus der Gruppe, bestehend aus Ammoniak, Kaliumhydroxid und einem quaternären Ammoniumhydroxid.

17. Verfahren zum Polieren einer zu polierenden Oberfläche, welches das Zuführen einer Polierzusammensetzung auf ein Polierpad und das Inkontaktbringen der zu polierenden Oberfläche mit dem Polierpad umfaßt, um das Polieren durch relative Bewegung zwischen ihnen durchzuführen, wobei die wie in einem der Ansprüche 1 bis 16 definierte Polierzusammensetzung bei einem Polierschritt verwendet wird, nachdem eine Sperrschicht durch Polieren einer Metallverdrahtungsschicht freigelegt ist.

## Revendications

1. Composition de polissage chimico-mécanique pour polir une surface devant être polie dans la production d'un dispositif à circuit intégré à semi-conducteur, laquelle comprend :
(A) de fines particules d'oxyde,
(B) du pullulane qui a un poids moléculaire moyen de 50 000 à 1 000 000, et
(C) de l'eau.

2. Composition de polissage selon la revendication 1, laquelle contient en outre :
(D) un agent oxydant, et
(E) un composé représenté par la formule 1 : 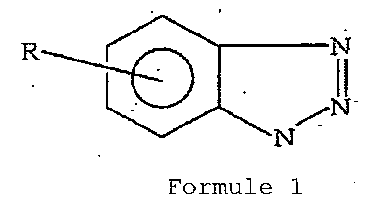 dans laquelle R est un atome d'hydrogène, un groupe alkyle en C₁ à C₄, un groupe alcoxy en C₁ à C₄ ou un groupe acide carboxylique.

3. Composition de polissage selon la revendication 1 ou 2, dans laquelle le composant (A) est constitué d'au moins une matière choisie dans le groupe constitué de silice, d'alumine, d'oxyde de cérium, d'oxyde de zirconium, d'oxyde de titane, d'oxyde d'étain, d'oxyde de zinc et d'oxyde de manganèse.

4. Composition de polissage selon l'une quelconque des revendications 1 à 3, dans laquelle le composant (A) est constitué de fines particules de silice.

5. Composition de polissage selon l'une quelconque des revendications 1 à 4, dans laquelle le composant (A) est présent en une quantité de 0,1 à 20 % en masse, le composant (B) est présent en une quantité de 0,005 à 20 % en masse, et le composant (C) est présent en une quantité de 40 à 98 % en masse, par rapport à la masse totale de la composition de polissage.

6. Composition de polissage selon l'une quelconque des revendications 2 à 5, dans laquelle le composant (D) est présent en une quantité de 0,01 à 50 % en masse, et le composant (E) est présent en une quantité de 0,001 à 5 % en masse, par rapport à la masse totale de la composition de polissage.

7. Composition de polissage selon l'une quelconque des revendications 1 à 6, dans laquelle le composant (A) est présent en une quantité de 1 à 15 % en masse, par rapport à la masse totale de la composition de polissage.

8. Composition de polissage selon l'une quelconque des revendications 1 à 7, dans laquelle le composant (C) est présent en une quantité de 60 à 90 % en masse, par rapport à la masse totale de la composition de polissage.

9. Composition de polissage selon l'une quelconque des revendications 1 à 8, dans laquelle le composant (D) est présent en une quantité de 0,5 à 5 % en masse, par rapport à la masse totale de la composition de polissage.

10. Composition de polissage selon l'une quelconque des revendications 1 à 9, dans laquelle le composant (E) est présent en une quantité de 0,01 à 0,5 % en masse, par rapport à la masse totale de la composition de polissage.

11. Composition de polissage selon l'une quelconque des revendications 1 à 10, dans laquelle les fines particules d'oxyde ont un diamètre moyen de particule de 5 à 500 nm.

12. Composition de polissage selon la revendication 11, dans laquelle les fines particules d'oxyde ont un diamètre moyen de particule de 10 à 300 nm.

13. Composition de polissage selon l'une quelconque des revendications 1 à 12, dans laquelle le composant (B) a un poids moléculaire moyen de 50 000 à 300 000.

14. Composition de polissage selon l'une quelconque des revendications 1 à 13, laquelle comprend en outre un acide choisi dans le groupe constitué de l'acide nitrique, de l'acide sulfurique et de l'acide carboxylique.

15. Composition de polissage selon la revendication 14, dans laquelle l'acide est présent en une quantité de 0,01 à 20 % en masse, par rapport à la masse totale de la composition de polissage.

16. Composition de polissage selon la revendication 14 ou 15, laquelle comprend de plus un composé basique choisi dans le groupe constitué d'ammoniaque, d'hydroxyde de potassium et d'hydroxyde d'ammonium quaternaire.

17. Procédé pour polir une surface à polir, qui comprend l'acheminement d'une composition de polissage jusqu'à un tampon polissant, et la mise en contact de la surface à polir avec le tampon polissant, afin d'exécuter un polissage par un mouvement relatif entre ceux-ci, dans lequel la composition de polissage telle que définie dans l'une quelconque des revendications 1 à 16 est utilisée à une étape de polissage après qu'une couche barrière a été exposée par polissage d'une couche de câblage en métal.
